(19) Europäisches Patentamt
European Patent Office
Office européen des brevets

(11) **EP 1 223 673 B1**

(12) **EUROPÄISCHE PATENTSCHRIFT**

(45) Veröffentlichungstag und Bekanntmachung des Hinweises auf die Patenterteilung:
**19.08.2009   Patentblatt 2009/34**

(51) Int Cl.:
*H03H 3/04* (2006.01)         *G04G 3/04* (2006.01)

(21) Anmeldenummer: **01124636.0**

(22) Anmeldetag: **16.10.2001**

(54) **Verfahren und Vorrichtung zur Korrektur von Frequenzabweichungen bei einem Schwingquarz**

Method and device for correcting frequency deviations in a quartz resonator

Procédé et disposif de correction de déviations de fréquence dans un résonateur à quartz

(84) Benannte Vertragsstaaten:
**AT CH DE LI**

(30) Priorität: **11.01.2001   DE 10100865**

(43) Veröffentlichungstag der Anmeldung:
**17.07.2002   Patentblatt 2002/29**

(73) Patentinhaber: **Techem Energy Services GmbH
65760 Eschborn (DE)**

(72) Erfinder: **Hansing, Martin, Dipl.-Inf.
65931 Frankfurt am Main (DE)**

(74) Vertreter: **KEIL & SCHAAFHAUSEN
Patentanwälte
Cronstettenstraße 66
60322 Frankfurt am Main (DE)**

(56) Entgegenhaltungen:
**GB-A- 2 328 568          US-A- 4 380 745
US-A- 4 473 303          US-A- 5 771 180**

**Beschreibung**

Die Erfindung betrifft ein Verfahren zur Korrektur von Frequenzabweichungen bei einem Schwingquarz, insbesondere für die zeitliche Festlegung von Sende- und/oder Empfangszeitschlitzen bei drahtlosen Kommunikationseinrichtungen, sowie eine Vorrichtung zur Durchführung des Verfahrens.

Bei batteriebetriebenen Endgeräten findet eine drahtlose Datenübertragung zur Stromersparnis meist nur in aufeinander abgestimmten Sende- und Empfangszeitfenstern von kurzer Dauer statt, da ein eingeschalteter HF-Sender oder HF-Empfänger ein Vielfaches des Ruhestromes des Gerätes verbraucht. Die Dauer der Zeitfenster liegt im Bereich von Millisekunden. Daher müssen die vergleichsweise kurzen Zeitfenster zeitlich exakt positioniert werden, damit Sender- und Empfängerzeitfenster sich treffen und eine zuverlässige Übertragung gewährleistet wird.

Die dazu notwendige Zeitinformation erhält das Gerät mit Hilfe eines Schwingquarzes, indem die Anzahl der Schwingungen des Quarzes gezählt und in eine Zeit umgerechnet werden. Allerdings hängt die Anzahl der Schwingungen unter anderem von der Temperatur des Schwingquarzes ab. Um eine genaue Positionierung der Zeitfenster zu erreichen, müssen insbesondere die temperaturbedingten Frequenzabweichungen des Schwingquarzes korrigiert werden.

Zur Korrektur der temperaturbedingten Frequenzabweichungen bei Schwingquarzen wurden bisher elektronische Bausteine eingesetzt, die eine analoge Korrektur durchgeführt haben. Beispielsweise sind sog. TCXO-Schwingquarze (Tempature Compensated Crystal Oscillator) bekannt, bei denen mit Hilfe von Dioden die Oszillatorfrequenz beeinflusst wird. Auf Grund der zusätzlichen elektronischen Bauteile sind derartige temperaturkompensierte Schwingquarze aber vergleichsweise teuer.

In US 5,771,180 wird eine Real Time Clock auf Basis eines Oszillators beschrieben, dessen Oszillatorsignale gezählt und mit Korrekturwerten korrigiert werden, welche in einem Speicher der Real Time Clock fest eingespeichert sind. Dazu wird die Temperatur des Oszillators gemessen und die Differenz zu einer Referenztemperatur gebildet. Auf Grundlage dieser Differenz wird dann der digitale Zähler, welcher die Schwingungen des Oszillators zählt, korrigiert. Um die temperaturabhängigen Korrekturwerte zu bestimmen, wird die Frequenz des Oszillators bei mehreren verschiedenen Temperaturen zwischen 0° C und 80° C gemessen und aufbereitet als Temperaturkorrekturtabelle in dem System gespeichert. Durch diese Bestimmung der Korrekturwerte wird also der gesamte interessierende Temperaturbereich vermessen und der zu jeder Temperatur gehörende Korrekturwert in dem Speicher abgelegt.

Die US 4,380,745 betrifft ein Verfahren zur Temperaturkompensation in einem Oszillatorsystem mit einer Fehlerkurve, bei der in einem Speicher zu vorgegebenen Temperaturen bestimmte Korrekturwerte gespeichert sind, um temperaturabhängig auf die gewünschte Schwingungszahl des Oszillators zu kommen. Dazu wird der gesamte Temperaturbereich vermessen und zu jeder Temperatur in dem gesamten Temperaturbereich der entsprechende Korrekturwert in einer Fehlertabelle festgelegt.

In der US 4,473,303 wird ein Temperaturkompensationsschaltkreis für Quarzkristalloszillatoren mit einem eigenen, temperaturmessenden Oszillatorschaltkreis mit linearer Temperaturabhängigkeit offenbart. Die vorgeschlagene Temperaturkompensation findet zweistufig statt, wobei einerseits die Frequenz des Quarzkristalloszillators gesteuert und andererseits in diskreten Schritten eine Kompensation auf Basis einer Temperaturmessung vorgenommen wird. Dabei wird auf Basis der Temperaturmessung eine Temperatur-Charakteristik zweiter Ordnung in der Temperatur errechnet, die exakt das Inverse der Frequenz-Temperatur-Charakteristik des Quarzkristalloszillatorschaltkreises ist.

Aufgabe der vorliegenden Erfindung ist es, die Frequenzabweichungen bei Schwingquarzen einfach und kostengünstig zu korrigieren.

Diese Aufgabe wird durch ein Verfahren mit den Merkmalen des Anspruchs 1 gelöst. Dabei ist insbesondere vorgesehen, dass die Temperatur des Schwingquarzes mittels eines Temperatursensors bestimmt wird und dass die Anzahl der gezählten Schwingungen des Schwingquarzes jeweils durch temperaturabhängige Korrekturwerte verändert wird. Durch das erfindungsgemäße Verfahren findet also eine digitale Korrektur der Frequenzabweichungen des Schwingquarzes statt, die elektronisch wesentlich einfacher zu realisieren ist als die bekannten analogen Korrekturen. Die meisten Endgeräte weisen bereits Mikrocontroller mit einer Uhrenfunktion auf, um aus der Anzahl der Schwingungen des Schwingquarzes (Systemtakt) einen grober aufgelösten Zeittakt abzuleiten oder eine Uhrzeit im Format Stunden-Minuten-Sekunden zur Verfügung zu stellen. Dies ist insbesondere bei drahtlosen Kommunikationsgeräten der Fall, wenn diese in aufeinander abgestimmten Zeitfenstern senden oder empfangen sollen. Bei in der Regel batteriebetriebenen Temperaturreglern oder Erfassungsgeräten für Heizenergie (elektronische Heizkostenverteiler), bei denen das erfindungsgemäße Verfahren besonders vorteilhaft anwendbar ist, befindet sich häufig auch ein Temperatursensor im Gerätegehäuse. Dann kann das erfindungsgemäße Verfahren einfach durch Implementierung einer neuen Software in den bereits vorhandenen Mikrocontroller eingerichtet werden, ohne dass zusätzliche elektronische Bauteile notwendig sind. Die am Sensor gemessene Temperatur stimmt dabei oft gut mit der Temperatur der gesamten Elektronikbaugruppe und des taktbestimmenden Schwingquarzes überein. Wenn dies nicht gegeben ist, kann aus dem physikalischen Zusammenhang zwischen der gemessenen Sensortemperatur und der Schwingquarztemperatur die tatsächliche Quarztemperatur rechnerisch bestimmt werden.

Um die Symmetrieeigenschaften des Schwingquarzes um einen Sollarbeits-Temperaturwert auszunutzen, ist erfindungsgemäß vorgesehen, dass die Korrekturwerte von dem Betrag der Temperaturdifferenz zwischen dem von dem Temperatursensor ermittelten Temperaturwert und dem Sollarbeits-Temperaturwert des Schwingquarzes abhängen. Damit lässt sich die Anzahl der vorzugebenden Korrekturwerte und -bereiche und damit auch der notwendigen Programmabfragen etwa um die Hälfte reduzieren, die Temperatur des Schwingquarzes in zwei Temperaturbereiche oberhalb und unterhalb des Sollarbeits-Temperaturwerts Ts eingeteilt wird, welche durch Spiegelung um den Sollarbeits-Temperaturwert Ts aufeinander abgebildet werden.

Dazu wird erfindungsgemäß der Arbeitsbereich des Schwingquarzes in einen ersten Temperaturbereich oberhalb und einen zweiten Temperaturbereich unterhalb des Sollarbeits-Temperaturwertes unterteilt und überprüft, ob der ermittelte Temperaturwert des Schwingquarzes in dem ersten Temperaturbereich liegt. In diesem Fall wird durch Subtraktion des ermittelten Temperaturwertes von dem Zweifachen des Sollarbeits-Temperaturwertes ein neuer Temperaturwert bestimmt, der im zweiten Temperaturbereich liegt. Durch die Abbildung des Temperaturwertes aus dem ersten Temperaturbereich auf einen Temperaturwert aus dem zweiten Temperaturbereich wird die Betragsbildung der Temperaturdifferenz zwischen dem Sollarbeits-Temperaturwert und dem ermittelten Temperaturwert ohne aufwendige Rechenoperationen erreicht. Besonders geeignet ist eine nur von dem Betrag der Temperaturdifferenz abhängige Korrekturwertbestimmung bei Schwingquarzen mit quadratischer Fehlerkurve.

Zur weiteren Vereinfachung der Korrekturwertbestimmung können jeweils für bestimmte Temperaturintervalle feste Korrekturwerte verwendet werden.

In einer bevorzugten Ausführung des erfindungsgemäßen Verfahrens wird der Temperaturwert durch sukzessiven Vergleich mit Schwellenwerten einem Temperaturintervall zugeordnet, wobei die Schwellenwerte derart sortiert sind, dass bei einem positiven Vergleichsergebnis das Temperaturintervall mit dem zugehörigen Korrekturwert festgelegt ist und die Vergleichsoperationen abgebrochen werden. Dadurch lässt sich die Anzahl der Rechenoperationen und damit der Stromverbrauch weiter minimieren. Zusätzlich kann die Reihenfolge der Vergleichsoperationen so angeordnet sein, dass zunächst die wahrscheinlichsten Temperaturwerte um die Sollarbeits-Temperatur des Schwingquarzes abgefragt werden, wodurch eine weitere Reduzierung der Rechenoperationen erreichbar ist.

Ferner kann erfindungsgemäß vorgesehen sein, dass die Korrekturwerte aus einer Parametrisierung der Fehlerkurve des Schwingquarzes ermittelt werden, wobei die Fehlerkurve die temperaturabhängigen Abweichungen in der Anzahl der Schwingungen angibt und ggf. mittels eines Drei-Punktabgleichs der Scheitelpunkt und die Krümmung der Fehlerkurve bestimmt wird. Durch die genaue Bestimmung der Fehlerkurve wird die Qualität der Frequenzkorrektur weiter verbessert. Zudem lassen sich auf diese Weise auch produktionsbedingte Frequenzabweichungen des Schwingquarzes berücksichtigen. Die Korrektur alterungsbedingter Frequenzabweichungen über die Lebensdauer des Quarzes kann mit einer initialen Produktionsprogrammierung zwar nicht erreicht werden. Um die Effekte der Alterung gering zu halten, können Quarze jedoch vorgealtert werden. Dies ist sinnvoll, weil Alterungstoleranzen über die Lebensdauer näherungsweise logarithmisch verlaufen, also die Zunahme des Frequenzfehlers durch Altern von Jahr zu Jahr geringer wird. Eine Grundabweichung der Quarzsollfrequenz $f_0$ (i. d. R. $f_0 = f(25°C)$) ist mit einem Produktionsabgleich kompensierbar.

Bei nicht quadratischen Fehlerkurven, beispielsweise bei Schwingquarzen mit kubischer Fehlerkurve, wie AT-Cut-Quarzen, können die Korrekturwerte auch von dem Vorzeichen der Temperaturdifferenz zwischen dem von dem Temperatursensor ermittelten Temperaturwert und dem Sollarbeits-Temperaturwert des Schwingquarzes abhängen. Damit lassen sich bspw. für Quarze mit kubischer Fehlerkurve die Symmetrieachsen durch den Wendepunkt der Fehlerkurve legen und dadurch die Anzahl der Vergleichsoperationen im Korrekturverfahren verringern.

Erfindungsgemäß wird die Korrektur der Frequenzabweichungen jeweils nach einer festgelegten Anzahl von Schwingungen des Schwingquarzes durchgeführt, um eine regelmäßige Korrektur zu erreichen. Durch eine geeignete Wahl der Anzahl von Schwingungen vor der Korrektur kann eine gewünschte Korrekturgenauigkeit eingestellt werden.

Bei typischen Anwendungen des erfindungsgemäßen Verfahrens bei Temperaturreglern oder Heizkostenverteilern hat es sich als vorteilhaft erwiesen, wenn die festgelegte Anzahl von Schwingungen des Schwingquarzes etwa einer Minute entspricht, da Temperaturschwankungen im Minutenabstand im Wohnungsbereich als ausreichend klein angesehen werden.

Ferner betrifft die Erfindung eine Vorrichtung gemäß Anspruch 10.

Dabei kann der Temperatursensor benachbart zu dem Schwingquarz angeordnet sein, damit die Schwingungseigenschaften des Schwingquarzes nicht durch einen auf dessen Oberfläche aufgesetzten Temperatursensor beeinträchtigt werden. Der neben dem Schwingquarz angeordnete Temperatursensor ist in der Regel denselben Temperaturen ausgesetzt wie der Schwingquarz selbst.

Nachfolgend wird eine Ausführungsform der vorliegenden Erfindung mit Bezug auf die Zeichnung näher beschrieben.

Es zeigen:

Fig. 1    die quadratische Fehlerkurve eines Schwingquarzes sowie eine geeignete Korrekturfunktion;

Fig. 2    ein Flussdiagramm des erfindungsgemäßen Verfahrens;

Fig. 3    den relativen Temperaturfehler in der Anzahl der Schwingungen nach Anwendung des erfindungsgemäßen Korrekturverfahrens in einem ersten Fall und

Fig. 4    den relativen Temperaturfehler in der Anzahl der Schwingungen nach Anwendung des erfindungsgemäßen Korrekturverfahrens in einem zweiten Fall.

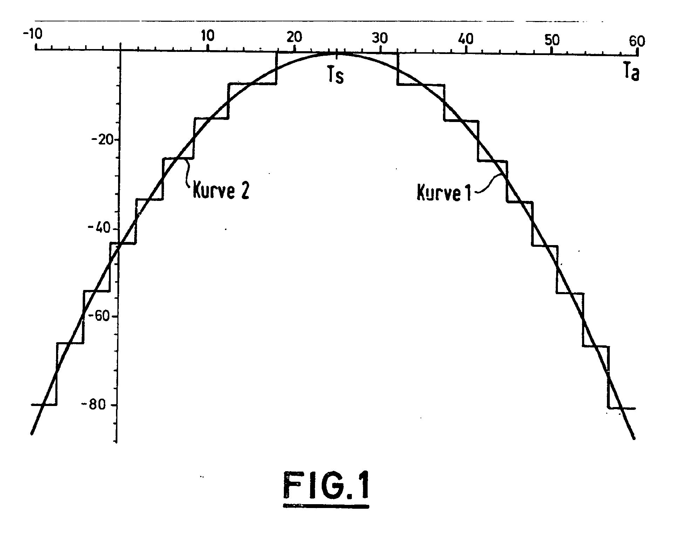

In Fig. 1 ist als Kurve 1 die quadratische Fehlerkurve eines typischen Schwingquarzes als Funktion der Arbeitstemperatur Ta dargestellt. Die Fehlerkurve gibt die Abweichung in der Anzahl der Schwingungen pro Minute für einen typischen Uhrenquarz mit einer geringen Nominalfrequenz von 32768 Hz an. Der Zeitabschnitt von einer Minute entspricht bei dieser Nominalfrequenz genau 1966080 Nominalschwingungen.

Da die Abweichungen im Bereich einiger ppm liegen, kann der Frequenzfehler des Quarzes ganzzahlig nur in relativ großen Zeitabschnitten korrigiert werden. Allerdings dürfen die Zeitabstände zwischen den Frequenzkorrekturen nicht so groß werden, dass die Temperaturschwankungen eine Bestimmung der relevanten Quarztemperatur verfälschen. Ganzzahlige Frequenzkorrekturen im Minutenabstand mit einer Auflösung von etwa einem halben ppm haben zu guten Ergebnissen geführt. Die sich ergebenden Temperaturschwankungen im Minutenabstand werden insbesondere im Wohnbereich als ausreichend klein angenommen.

Die zugrundeliegenden Parameter für die dargestellte Fehlerkurve eines typischen Schwingquarzes sind ein parabolischer Temperaturkoeffizient von -0,036 ppm/°C$^2$ und eine Scheiteltemperatur von 25°C.

Die als Kurve 2 gezeigte Korrekturfunktion ist eine als Parametrisierung über die Fehlerkurve des Schwingquarzes gelegte Treppenfunktion, aus der sich für das jeweilige Temperaturintervall die Abweichung in der Anzahl der Schwingungen des Schwingquarzes als Korrekturwert ablesen lassen, um den die tatsächlich gezählte Anzahl der Schwingungen korrigiert werden muss. Sowohl die Fehlerkurve als auch die Korrekturfunktion sind um einen Sollarbeits-Temperaturwert Ts (Scheiteltemperatur) symmetrisch. Aufgrund der Symmetrie hängen die Korrekturwerte nur von dem Betrag der Temperaturdifferenz zwischen dem ermittelten Ist-Temperaturwert Ta für den Schwingquarz und dem Sollarbeits-Temperaturwert Ts ab. Die Temperatur des Schwingquarzes kann in einen ersten Temperaturbereich oberhalb des Sollarbeits-Temperaturwertes Ts und einen zweiten Temperaturbereich unterhalb des Sollarbeits-Temperaturwertes Ts eingeteilt werden. Beide Temperaturbereiche können durch Spiegelung um den Sollarbeits-Temperaturwert Ts aufeinander abgebildet werden. Im Falle einer kubischen Fehlerkurve muss zusätzlich das Vorzeichen der Temperaturdifferenz beachtet werden.

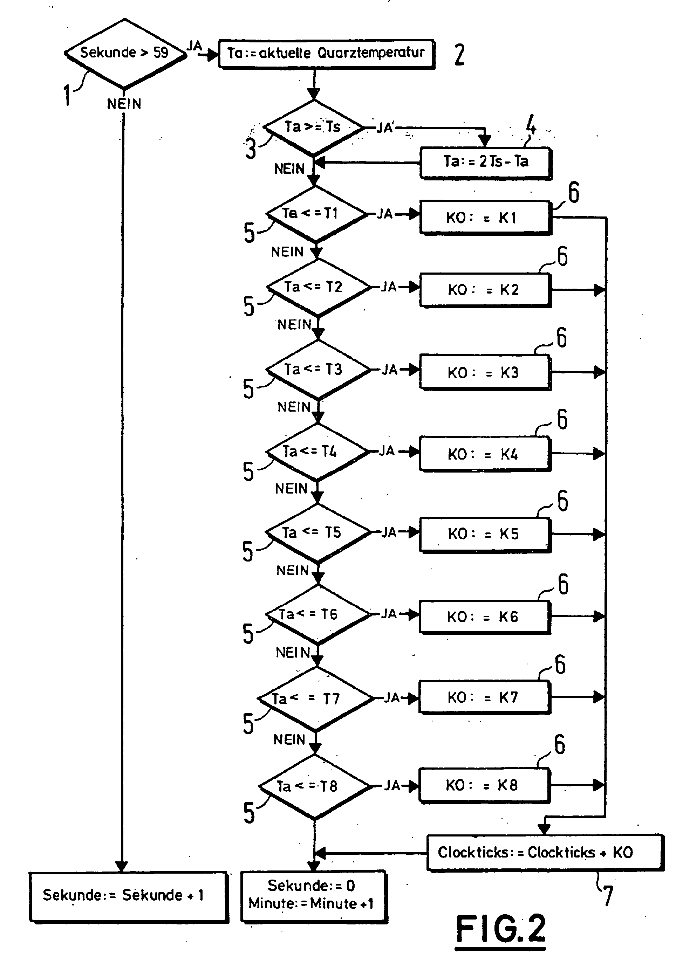

Das aus den vorangegangenen Überlegungen abgeleitete Verfahren zur Frequenzkorrektur bei dem Schwingquarz ist als Flussdiagramm in Fig. 2 dargestellt. In einem Rechenwerk wird während der Umsetzung der gezählten Schwingungen des Schwingquarzes in eine Uhrzeit mittels einer entsprechenden Uhrenroutine überprüft, ob seit der letzten Frequenzkorrektur bereits eine Minute vergangen ist. Diese Prüfung findet in der Zeitabfrage 1 im Sekundenrhythmus statt. Sobald eine Minute vergangen ist, wird die Frequenzkorrektur eingeleitet, indem die aktuell von dem Temperatursensor ermittelte Quarztemperatur in einer Temperaturwertzuweisung 2 dem Temperaturwert Ta zugewiesen wird.

In einer sich anschließenden Temperaturabfrage 3 wird abgefragt, ob der Temperaturwert Ta größer ist als der Sollarbeits-Temperaturwert Ts des Schwingquarzes bzw. eines festgelegten Schwellenwertes, der einen akzeptablen Temperaturbereich begrenzt, in dem eine Frequenzkorrektur nicht erforderlich ist. In diesem Fall liegt der Temperaturwert Ta in dem ersten Temperaturbereich und wird in einer Temperaturwertanpassung 4 durch Subtraktion von dem Zweifachen des Sollarbeits-Temperaturwertes Ts in einen neuen Temperaturwert Ta in dem zweiten Temperaturbereich überführt, dessen Differenz zu dem Sollarbeits-Temperaturwert Ts denselben Betrag aufweist wie der ursprüngliche Temperaturwert Ta. Durch diese Abfrage und gegebenenfalls die Überführung des Temperaturwertes Ta aus dem ersten in den zweiten Temperaturbereich des Schwingquarzes werden die Symmetrieeigenschaften der Fehlerkurve ausgenutzt und die Anzahl der nötigen Abfragen zur Ermittlung eines Korrekturwertes reduziert.

Nachfolgend wird in sukzessiven Temperaturvergleichen 5 überprüft, ob der Temperaturwert Ta innerhalb bestimmter Temperaturintervalle liegt. Dazu wird der Temperaturwert Ta jeweils mit Schwellenwerten T1 bis Tn verglichen. Sobald die Zuordnung des Temperaturwertes Ta zu einem Temperaturintervall feststeht, wird einem Korrekturoffset KO in einer Korrekturwertzuweisung 6 ein dem jeweiligen Temperaturintervall entsprechender Korrekturwert K1 bis Kn zugewiesen und die sukzessiven Temperaturvergleiche 5 werden abgebrochen.

Zum Abschluss der Frequenzkorrektur wird der Korrekturoffset KO in einer Korrekturberechnung 7 zu der Anzahl der gezählten Schwingungen des Schwingquarzes (Clockticks) hinzugezählt. In einem ersten Intervall um den Sollarbeits-Temperaturwert Ts (bspw. Ts ± 7°C) muss kein Korrekturoffset KO zu den Clockticks hinzu gezählt werden. In diesem Fall wird der Temperaturwert Ta einfach keinem Temperaturintervall zugeordnet, so dass weder eine Korrekturwertzuweisung 6 noch eine Korrekturberechnung 7 durchgeführt wird. Anschließend wird noch der Sekundenzähler zurückgesetzt und der Minutenzähler inkrementiert.

Danach wird erneut im Sekundenrhythmus überprüft, ob eine Frequenzkorrektur durchgeführt werden muss, die nach einer Minute neu eingeleitet wird.

Im dargestellten Beispiel wurde der zweite Temperaturbereich in insgesamt acht Temperaturintervalle mit jeweils eigenen Korrekturwerten K1 bis K8 eingeteilt. Damit wird der temperaturabhängige Quarzfehler im Bereich von in -10 °C bis +60 °C korrigiert. Je nach den Anforderungen an den Temperaturbereich oder die Genauigkeit können jedoch auch mehr oder weniger Temperaturintervalle Tn mit jeweils eigenständigen Korrekturwerten Kn verwendet werden.

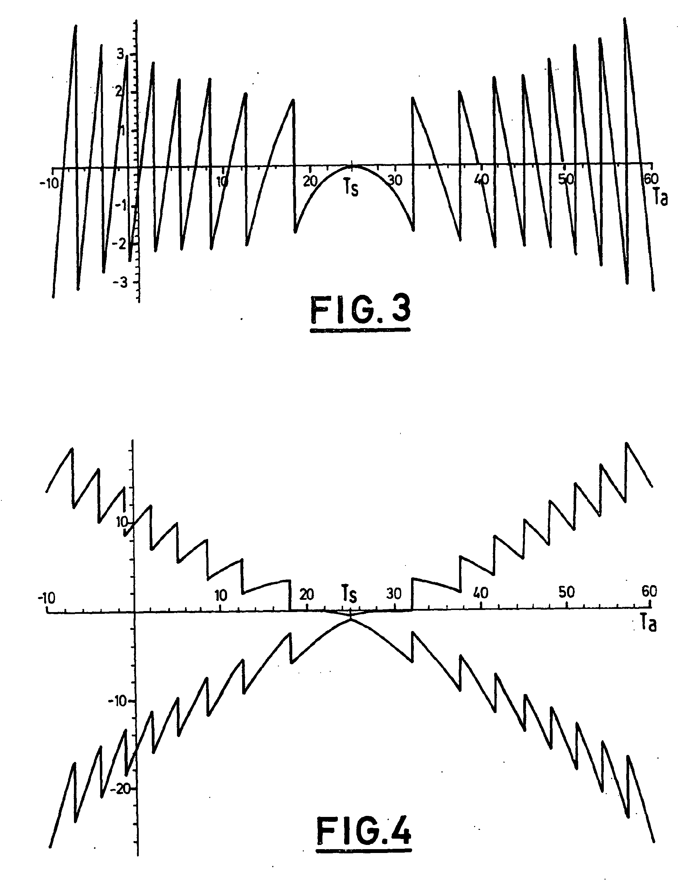

In Fig. 3 ist das Ergebnis der zuvor beschriebenen Korrektur als relativer Temperaturfehler in ppm als Funktion des Temperaturwertes Ta dargestellt. Über den gesamten Temperaturbereich von -10 °C bis + 60 °C kann der verbleibende Fehler auf $\pm 4$ ppm begrenzt werden. Im relevanten Bereich von 0 °C bis 50 °C kann sogar von maximal $\pm 3$ ppm ausgegangen werden. Unkorrigiert ergeben sich dagegen temperaturabhängige Fehler von -22.5 bis 0 ppm, so dass sich mit der Erfindung eine Verbesserung von 16.5 ppm erreichen lässt. Aus dem parabelförmigen Verlauf um den Sollarbeits-Temperaturwert Ts (Scheitelpunkt der Fehlerkurve) lässt sich ablesen, dass in diesem ersten Temperaturintervall um den Sollarbeits-Temperaturwert Ts keine Frequenzkorrektur durchgeführt wurde.

Fig. 4 zeigt das Ergebnis einer Korrektur, bei der der tatsächliche parabolische Temperaturkoeffizient und die tatsächliche Scheiteltemperatur der Fehlerkurve um etwa 20 Prozent von den angenommenen Werten abweichen. In diesen Fällen sind die Korrekturkurven je nach Abweichungsrichtung geneigt und die Qualität der Korrektur verschlechtert sich in dem relevanten Bereich von 0 °C bis 50° C auf etwa -16 ppm bis + 12 ppm. Unkorrigiert lägen die temperaturabhängigen Fehler bis ca. -38 ppm bis 0 ppm. Es ergibt sich somit eine Verbesserung von ca. 10 ppm.

Es ist sinnvoll, die Parameter der Fehlerkurve mittels eines Drei-Punktabgleichs zu ermitteln, um eine hohe Qualität der Korrektur zu erreichen. Bei einem solchen Drei-Punktabgleich werden aus drei ermittelten Punkten der Fehlerkurve anhand der bekannten funktionalen Abhängigkeit der parabolische Temperaturkoeffizient und die Scheiteltemperatur (Sollarbeits-Temperaturwert Ts) ermittelt. Hierbei berücksichtigt man, dass Uhrenquarze mit einer Nominalfrequenz von 32768 Hz typischerweise Schnittwinkel haben, so dass sich für den temperaturabhängigen Frequenzverlauf f(t) eine nach unten geöffnete Parabel ergibt. Die Parabel lässt sich mathematisch als Polynom zweiten Grades wie folgt beschreiben:

$$f(t) = a \cdot t^2 + b \cdot t + c$$

Sind drei Messpunkte $[t_1, f(t_1)]$, $[t_2, f(t_2)]$ und $[t_3, f(t_3)]$ als Paare aus Temperatur $t_i$ und zugeordneter Quarzfrequenz $f(t_i)$ gegeben, dann lassen sich die drei Koeffizienten a, b und c durch Lagrangeinterpolation eindeutig bestimmen. Mit der Abkürzung $f_i = f(t_i)$ ergeben sich a, b und c zu:

$$a = \frac{f_3 \cdot (t_1 - t_2) + f_2 \cdot (t_3 - t_1) + f_1 \cdot (t_2 - t_3)}{(t_1 - t_2) \cdot (t_1 - t_3) \cdot (t_2 - t_3)}$$

$$b = \frac{f_3 \cdot (t_2^2 - t_1^2) + f_2 \cdot (t_1^2 - t_3^2) + f_1 \cdot (t_3^2 - t_2^2)}{(t_1 - t_2) \cdot (t_1 - t_3) \cdot (t_2 - t_3)}$$

$$c = \frac{f_3 \cdot t_2 \cdot t_1 \cdot (t_1 - t_2) + f_2 \cdot t_3 \cdot t_1 \cdot (t_3 - t_1) + f_1 \cdot t_3 \cdot t_2 \cdot (t_2 - t_3)}{(t_1 - t_2) \cdot (t_1 - t_3) \cdot (t_2 - t_3)}$$

Üblich ist es, die Frequenzparabel f(t) des Quarzes durch die Scheiteltemperatur $t_S$, einen Krümmungskoeffizienten k und die Nominalfrequenz im Scheitelpunkt $f_S = f(t_S)$ zu beschreiben. Mathematisch formuliert gilt:

$$f(t) = k \cdot (t_S - t)^2 + f_S$$

Durch Koeffizientenvergleich mit der obigen Darstellung ergeben sich k, $t_S$ und $f_S$ zu:

$$k = a, \quad t_S = -\frac{b}{2 \cdot a}, \quad f_S = c - \frac{b^2}{4 \cdot a}$$

Sind also mindestens drei Messwerte der Quarzfrequenz für drei verschiedene Arbeitstemperaturen bekannt, lassen sich die Polynomkoeffizienten a, b und c bzw. die Parabelkoeffizienten k, $t_S$ und $f_S$ eindeutig bestimmen. Mit der Scheiteltemperatur ist sowohl die Entscheidungsschwelle Ta $\geq T_S$ für das skizzierte Korrekturverfahren gegeben, als auch die Umrechnung Ta := $2T_S$ -Ta . Die Temperaturschwellen $T_1$ bis $T_N$ und die zugehörigen Korrekturwerte $K_1$ bis $K_N$ lassen sich nun ebenfalls rechnerisch an den Kurvenverlauf anpassen. In der Produktion können diese Parameter in das Endgerät programmiert werden. Dabei findet die etwas aufwendige Berechnung der individuellen Geräteparameter auf Produktionsmitteln statt und nicht in den meist kostensensitiven Endgeräten.

Die Lagrange -Interpolation ist neben dem oben beschriebenen Fall einer quadratischen Frequenzkurve auch für Polynome dritten Grades anwendbar.

Schließlich ist auch ein Mehrpunktabgleich nach dem Regressionsverfahren denkbar, verursacht jedoch durch die zusätzliche, an sich unnötige Messung weitere Kosten.

Mit dem erfindungsgemäßen Verfahren zur insbesondere temperaturabhängigen Frequenzkorrektur ist es gelungen, eine effektive Korrektur der Abweichungen in der Anzahl der Schwingungen eines Schwingquarzes mit einfachen Mitteln zu erreichen. Das Verfahren benötigt nur einen äußerst geringen Rechenaufwand und kann platzsparend beispielsweise in Kommunikationseinrichtungen untergebracht werden, da nur ein vergleichsweise kostengünstiger Temperatursensor und ein Mikroprozessor benötigt werden. Häufig finden sich ein Temperatursensor und ein Mikroprozessor bereits in Endgeräten, wie Temperaturreglern oder Heizkostenverteilern mit drahtlosen Kommunikationseinrichtungen, so dass sich die Einrichtung dieser Endgeräte für das erfindungsgemäße Verfahren auf die Implementierung der entsprechenden Programmschritte in dem Mikroprozessor beschränkt.

**Bezugszeichenliste:**

| | |
|---|---|
| 1 | Zeitabfrage |
| 2 | Temperaturwertzuweisung |
| 3 | Temperaturabfrage |
| 4 | Temperaturwertanpassung |
| 5 | Temperaturvergleiche |
| 6 | Korrekturwertzuweisungen |
| 7 | Korrekturberechnung |
| Ta | Temperaturwert |
| Ts | Sollarbeits-Temperaturwert (Scheiteltemperatur) |
| KO | Korrekturoffset |
| K1 bis K8 | Korrekturwerte |
| T1 bis T8 | Schwellenwerte |
| Kurve 1 | Fehlerkurve des Schwingquarzes |
| Kurve 2 | Korrekturfunktion |

**Patentansprüche**

1. Verfahren zur Korrektur von Frequenzabweichungen bei einem Schwingquarz, insbesondere für die zeitliche Festlegung von Sende- und/oder Empfangszeitschlitzen bei drahtlosen Kommunikationseinrichtungen, wobei die Temperatur des Schwingquarzes mittels eines Temperatursensors bestimmt und die Anzahl der gezählten Schwingungen des Schwingquarzes jeweils durch temperaturabhängige Korrekturwerte K1 bis Kn verändert wird, **dadurch gekennzeichnet, dass** die Korrekturwerte K1 bis Kn von dem Betrag der Temperaturdifferenz zwischen dem von dem Temperatursensor ermittelten Temperaturwert Ta und einem Sollarbeits-Temperaturwert Ts des Schwingquarzes abhängen und die Temperatur des Schwingquarzes in zwei Temperaturbereiche oberhalb und unterhalb des Sollarbeits-Temperaturwerts Ts eingeteilt wird, welche durch Spiegelung um den Sollarbeits-Temperaturwert Ts aufeinander abgebildet werden.

2. Verfahren nach Anspruch 1, **dadurch gekennzeichnet, dass** überprüft wird, ob der ermittelte Temperaturwert Ta des Schwingquarzes in dem ersten, oberen Temperaturbereich liegt, und dass in diesem Fall ein neuer Temperaturwert Ta durch Subtraktion des ermittelten Temperaturwertes Ta von dem Zweifachen des Sollarbeits-Temperaturwertes Ts bestimmt wird.

3. Verfahren nach einem der vorhergehenden Ansprüche, **dadurch gekennzeichnet, dass** jeweils für bestimmte Temperaturintervalle feste Korrekturwerte K1 bis Kn verwendet werden.

4. Verfahren nach Anspruch 3, **dadurch gekennzeichnet, dass** der Temperaturwert Ta durch sukzessiven Vergleich mit Schwellenwerten T1 bis Tn einem Temperaturintervall zugeordnet wird, wobei die Schwellenwerte T1 bis Tn derart sortiert sind, dass bei einem positiven Vergleichsergebnis das Temperaturintervall mit dem zugehörigen Korrekturwert K1 bis Kn festgelegt ist und die Vergleichsoperationen abgebrochen werden.

5. Verfahren nach einem der vorhergehenden Ansprüche, **dadurch gekennzeichnet, dass** die Korrekturwerte K1 bis Kn aus einer Parametrisierung der Fehlerkurve des Schwingquarzes ermittelt werden, wobei die Fehlerkurve die temperaturabhängigen Abweichungen in der Anzahl der Schwingungen angibt und wobei mittels eines Drei-Punktabgleichs der Scheitelpunkt und die Krümmung der Fehlerkurve bestimmt werden.

6. Verfahren nach einem der vorhergehenden Ansprüche, **dadurch gekennzeichnet, dass** in einem ersten Temperaturintervall um den Sollarbeits-Temperaturwert Ts des Schwingquarzes keine Korrektur durchgeführt wird.

7. Verfahren nach einem der vorhergehenden Ansprüche, **dadurch gekennzeichnet, dass** die Korrekturwerte K1 bis Kn von dem Vorzeichen der Temperaturdifferenz zwischen dem von dem Temperatursensor ermittelten Temperaturwert Ta und dem Sollarbeits-Temperaturwert Ts des Schwingquarzes abhängen.

8. Verfahren nach einem der vorhergehenden Ansprüche, **dadurch gekennzeichnet, dass** die Korrektur der Frequenzabweichungen jeweils nach einer festgelegten Anzahl von Schwingungen des Schwingquarzes durchgeführt wird.

9. Verfahren nach Anspruch 8, **dadurch gekennzeichnet, dass** die festgelegte Anzahl von Schwingungen des Schwingquarzes etwa einer Minute entspricht.

10. Vorrichtung zur drahtlosen Kommunikation, insbesondere in batteriebetriebenen Endgeräten wie Temperaturreglern und Heizkostenverteilern, umfassend: einen Schwingquarz als absoluten Zeitgeber zur Festlegung von Sende- und Empfangszeitschlitzen für die Kommunikation mit anderen Sende- und/oder Empfangseinrichtungen, einen Temperatursensor zur Bestimmung der Temperatur des Schwingquarzes und ein Rechenwerk mit Programmschritten zur Korrektur von Frequenzabweichungen, wobei das Rechenwerk dazu eingerichtet ist, die Temperatur des Schwingquarzes mittels des Temperatursensors zu bestimmen und die Anzahl der gezählten Schwingungen des Schwingquarzes jeweils durch temperaturabhängige Korrekturwerte K1 bis Kn zu verändern, **dadurch gekennzeichnet, dass** die Korrekturwerte K1 bis Kn von dem Betrag der Temperaturdifferenz zwischen dem von dem Temperatursensor ermittelten Temperaturwert Ta und einem Sollarbeits-Temperaturwert Ts des Schwingquarzes abhängen, und dass das Rechenwerk dazu eingerichtet, ist, die Temperatur des Schwingquarzes in zwei Temperaturbereiche oberhalb und unterhalb des Sollarbeits-Temperaturwerts Ts einzuteilen, und die Temperaturbereiche durch Spiegelung um den Sollarbeits-Temperaturwert Ts aufeinander abzubilden.

11. Vorrichtung nach Anspruch 10, **dadurch gekennzeichnet, dass** der Temperatursensor benachbart zu dem Schwingquarz angeordnet ist.

**Claims**

1. Method and device for correcting frequency deviations in a quartz resonator, in particular for the temporal fixing of transmission and/or reception time slots in wireless communications devices, wherein the temperature of the quartz resonator is determined by means of a temperature sensor and the number of oscillations of the quartz resonator that are counted is modified by temperature-dependent correction factors K1 to Kn respectively,
**characterized in that**
said correction factors K1 to Kn depend on the size of the temperature difference between the temperature value Ta measured by the temperature sensor and a reference working temperature value Ts of the quartz resonator, and the temperature of the quartz resonator is sub-divided into two temperature ranges above and below the reference working temperature value Ts, which are mapped onto each other by reflection about the reference working temperature value Ts.

2. Method according to Claim 1,
**characterized in that**
a test is carried out as to whether the measured temperature value Ta of the quartz resonator lies in the first, upper temperature range, and that in this case a new temperature value Ta is determined by subtraction of the detected temperature value Ta from twice the reference working temperature value Ts.

3. Method according to any one of the preceding claims,
**characterized in that**
fixed correction factors K1 to Kn are used for specific temperature intervals respectively.

4. Method according to Claim 3,
**characterized in that**
the temperature value Ta is assigned to a temperature interval by successive comparison with threshold values T1 to Tn, wherein said threshold values are sorted in such a way that if the result of the comparison is positive, the temperature interval with the associated correction factor K1 to Kn is fixed and the comparison operation aborted.

5. Method according to any one of the preceding claims,
**characterized in that**
the correction factors K1 to Kn are determined from a parameterisation of the error curve of the quartz resonator, wherein the error curve indicates the temperature-dependent deviations in the number of oscillations and wherein the apex and the curvature of the error curve are determined by means of a three-point calibration method.

6. Method according to any one of the preceding claims,
**characterized in that**
in a first temperature interval about the reference working temperature value Ts of the quartz resonator, no correction is carried out.

7. Method according to any one of the preceding claims,
**characterized in that**
the correction factors K1 to Kn depend on the sign of the temperature difference between the temperature value Ta measured by the temperature sensor and the reference working temperature value Ts of the quartz resonator.

8. Method according to any one of the preceding claims,
**characterized in that**
the correction of the frequency deviations is carried out in each case after a specified number of oscillations of the quartz resonator.

9. Method according to Claim 8,
**characterized in that**
the specified number of oscillations of the quartz resonator corresponds to approximately one minute.

10. Device for wireless communication, in particular in battery-operated terminal devices such as temperature controllers and heating cost distributors, comprising:

    a quart resonator as an absolute timer for specifying transmission and reception time slots for communication with other transmission and/or receiving devices, a temperature sensor for determining the temperature of the quartz resonator, and an arithmetic unit with program steps for the correction of frequency deviations, wherein the arithmetic unit is arranged for the purpose of determining the temperature of the quartz resonator by means of the temperature sensor and for modifying the number of counted oscillations of the quartz resonator by temperature-dependent correction factors K1 to Kn respectively,

**characterized in that**

the correction values K1 to Kn depend on the size of the temperature difference between the temperature value Ta measured by the temperature sensor and a reference working temperature value Ts of the quartz resonator, and that

the arithmetic unit is arranged for the purpose of sub-dividing the temperature of the quartz resonator into two temperature ranges above and below the reference working temperature value Ts, and for mapping said temperature ranges onto each other by reflection about the reference working temperature value Ts.

11. Device according to Claim 10,
    **characterized in that**
    the temperature sensor is arranged adjacent to the quartz resonator.


**Revendications**

1. Procédé pour corriger des écarts de fréquence z dans un cristal oscillateur, en particulier pour la définition dans le temps de créneaux temporels d'émission et/ou d'émission dans le cas de dispositifs de communication sans fil, la température du cristal oscillateur étant déterminée au moyen d'un capteur de température et le nombre des oscillations comptées du cristal oscillateur étant modifié à chaque fois par des valeurs de correction K1 à Kn dépendantes de la température, **caractérisé en ce que** les valeurs de correction K1 à Kn dépendent de la somme de la différence de température entre la valeur de température Ta déterminé par le capteur de température et une valeur de température de travail prévue Ts du cristal oscillateur et la température du cristal oscillateur est divisée en deux plages de températures au-dessus et au-dessous de la valeur de température de travail prévue Ts, lesquelles sont représentées les unes sur les autres par la réflexion autour de la valeur de température de travail prescrit Ts.

2. Procédé selon la revendication 1, **caractérisé en ce qu'**on vérifie si la valeur de température Ta déterminée du cristal oscillateur se situe dans la première plage de température supérieure et **en ce que**, dans ce cas, une nouvelle valeur de température Ta est déterminée par soustraction de la valeur de température Ta déterminée du double de la valeur de température de travail prévue Ts.

3. Procédé selon l'une quelconque des revendications précédentes, **caractérisé en ce que** des valeurs de correction K1 à Kn fixes sont utilisées à chaque fois pour des intervalles de température définis.

4. Procédé selon la revendication 3, **caractérisé en ce que** la valeur de température Ta est attribuée par comparaison successive avec des valeurs seuils T1 à Tn à un intervalle de température, les valeurs seuils T1 à Tn étant triées de telle sorte que, dans le cas d'un résultat' de comparaison positif, l'intervalle de température est défini avec la valeur de correction K1 à Kn spécifique et les opérations de comparaison sont interrompues.

5. Procédé selon l'une quelconque des revendications précédentes, **caractérisé en ce que** les valeurs de correction K1 à Kn sont déterminées à partir d'un paramétrage de la courbe d'erreur du cristal oscillateur, la courbe d'erreur indiquant les écarts dépendants de la température dans le nombre des oscillations et le sommet et la courbure de la courbe d'erreur étant déterminés au moyen d'un ajustement en trois points.

6. Procédé selon l'une quelconque des revendications précédentes, **caractérisé en ce qu'**aucune correction n'est effectuée dans un premier intervalle de température autour de la valeur de température de travail prévue Ts du cristal oscillateur.

7. Procédé selon l'une quelconque des revendications précédentes, **caractérisé en ce que** les valeurs de correction K1 à Kn dépendent du signe de la différence de température entre la valeur de température Ta déterminée par le capteur de température et la valeur de température de travail prescrit Ts du cristal oscillateur.

8. Procédé selon l'une quelconque des revendications précédentes, **caractérisé en ce que** la correction des écarts de température est effectuée à chaque fois selon un nombre défini de vibrations du cristal oscillateur.

9. Procédé selon la revendication 8, **caractérisé en ce que** le nombre défini d'oscillations du cristal oscillateur correspond à peu près à une minute.

10. Dispositif pour la communication sans fil, en particulier dans des terminaux exploités sur batterie tels que des régulateurs de température et des répartiteurs de coûts de chauffage, comprenant : un cristal oscillateur comme générateur de rythme absolu pour la fixation de créneaux temporels d'émission et de réception, pour la communication avec d'autres dispositifs d'émission et/ou de réception, un capteur de température pour la détermination de la température du cristal oscillateur et une unité de calcul avec des étapes de programme pour la correction des écarts de fréquence, l'unité de calcul étant aménagée pour déterminer la température du cristal oscillateur au moyen du capteur de température et modifier le nombre des oscillations comptées du cristal oscillateur à chaque fois par des valeurs de correction K1 à Kn dépendantes de la température, **caractérisé en ce que** les valeurs de correction K1 à Kn dépendent de la somme de la différence de température entre la valeur de température Ta déterminée par le capteur de température et une valeur de température de travail prescrit Ts du cristal oscillateur et **en ce que** l'unité de calcul est aménagée pour diviser la température du cristal oscillateur en deux plages de températures au-dessus et au-dessous de la valeur de température de travail prescrite Ts et reproduire les plages de températures par réflexion autour de la valeur de température de travail prescrit Ts.

11. Dispositif selon la revendication 10, **caractérisé en ce que** le capteur de température est disposé à proximité du cristal oscillateur.

**FIG.1**

**FIG.2**

## FIG. 3

## FIG. 4

13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5771180 A
- US 4380745 A
- US 4473303 A